# EUROPÄISCHE PATENTANMELDUNG

(11) **EP 1 847 903 A2**
(43) Veröffentlichungstag der Anmeldung: **24.10.2007**
(21) Anmeldenummer: 06006248.6
(22) Anmeldetag: 27.03.2006

(54) **Graphische Simulationsumgebung und Verfahren zum Erzeugen einer graphischen Darstellung**

(71) Anmelder: SIEMENS AKTIENGESELLSCHAFT, 80333 München (DE)
(72) Erfinder: Brüll, Martin, 93092 Barbing (DE); Burger, Thomas, Dr., 93051 Regensburg (DE); Kunze, Marco, Dr., 93051 Regensburg (DE)

(57) **Zusammenfassung**

Die Erfindung betrifft graphische Simulationsumgebungen eines mathematischen Simulationsprogramms für die graphische Darstellung (40) einer zu simulierenden Funktion mittels Funktionsblöcken (41-53) mehrerer Blocktypen. Die Simulationsumgebung ist derart ausgeführt, dass die Größen der Funktionsblöcke (41-53) eines Blocktyps nur innerhalb von vorab definierten Kriterien manuell veränderbar sind. Alternativ ist die Simulationsumgebung derart ausgeführt, dass sich die Größen der Funktionsblöcke (41-53) eines Blocktyps aufgrund vorab definierter Kriterien während der Erstellung und/oder nach Fertigstellung der graphischen Darstellung (40) automatisch ändern. Die Erfindung betrifft auch ein Verfahren zum Erzeugen einer graphischen Darstellung (40).

## Beschreibung

Die Erfindung betrifft eine graphische Simulationsumgebung eines mathematischen Simulationsprogramms und ein Verfahren zum Erzeugen einer graphischen Darstellung.

Bei der Entwicklung u.a. von elektronischen Schaltungen, Steuerungen oder Regelungen, wie beispielsweise die Funktionen für eine Motorsteuerung, werden heute graphische Simulationsumgebungen verwendet. Die graphische Simulationsumgebung ist ein graphischer Editor, mit dem mittels Funktionsblöcken verschiedener Blocktypen z.B. Signalflusspläne oder Schaltpläne für elektronische Schaltungen als graphische Darstellung editiert werden, die anschließend mit einem Simulationsprogramm simuliert werden können. Ein Beispiel einer solchen graphischen Simulationsumgebung ist Simulink für das bekannte Matlab-Simulationsprogramm. Die graphische Darstellung kann u.a. auch für die Dokumentation verwendet werden.

Die Funktionsblöcke bekannter graphischer Simulationsumgebungen können vom Anwender in ihrer Größe frei angepasst werden. Die Lesbarkeit der graphischen Darstellung hängt jedoch von den anwenderabhängigen Größeneinstellungen der einzelnen Funktionsblöcke ab. Wegen der Möglichkeit, die Funktionsblöcke frei einzustellen, leidet in der Regel die Lesbarkeit der fertigen graphischen Darstellung, weshalb zur Erhöhung der Lesbarkeit der graphischen Darstellung eine aufwändige Umskalierung der einzelnen Funktionsblöcke für die Dokumentation notwendig ist.

Darüber hinaus würde eine derartige nachträgliche Umskalierung auch die Lage der Blöcke zueinander verändern, was zu einem weiteren aufwändigen Arbeitsschritt führen würde.

Die Aufgabe der vorliegenden Erfindung ist es daher, eine graphische Simulationsumgebung derart auszuführen, dass die Lesbarkeit der graphischen Darstellung der zu simulierenden Funktion verbessert wird.

Die Aufgabe der Erfindung wird gelöst durch eine graphische Simulationsumgebung eines mathematischen Simulationsprogramms für die graphische Darstellung einer zu simulierenden Funktion mittels Funktionsblöcken mehrerer Blocktypen, dadurch gekennzeichnet, dass die Größen der Funktionsblöcke eines Blocktyps nur innerhalb von vorab definierten Kriterien manuell veränderbar sind. Aufgrund der vorab definierten festgelegten Kriterien ist der Anwender bei der manuellen Veränderung der dargestellten Größe der einzelnen Funktionsblöcke zumindest eingeschränkt, wodurch Voraussetzungen für eine bessere Lesbarkeit der fertigen graphischen Darstellung gegeben sind.

Gemäß Ausführungsformen der erfindungsgemäßen graphischen Simulationsumgebung ist aufgrund der vorab definierten Kriterien die Größe von Funktionsblöcken eines Blocktyps in wenigstens einer Richtung unveränderbar, bleibt eine relative Seitenlänge von Funktionsblöcken eines Blocktyps bei einer manuellen Veränderung eines dieser Funktionsblöcke erhalten oder ist eine Verstellschrittweite eines Funktionsblocks eines Blocktyps vorgegeben.

Wenn nach einer bevorzugten Variante der erfindungsgemäßen graphischen Simulationsumgebung aufgrund der vorab definierten Kriterien ein Funktionsblock eines Blocktyps nur bis zu einer vorgegebenen Maximalgröße veränderbar ist, sind Voraussetzungen dafür geschaffen, dass sich die Größe von für die graphische Darstellung verwendeter Funktionsblöcke desselben Blocktyps lediglich innerhalb der vorgegebener Grenzen unterscheiden. Dies erhöht die Lesbarkeit der fertigen graphischen Darstellung.

Nach einer besonders bevorzugten Ausführungsform der erfindungsgemäßen graphischen Simulationsumgebung kann die Größe eines Funktionsblocks eines Blocktyps manuell nicht verändert werden. Dadurch erkennt ein Betrachter der graphischen Darstellung relativ einfach Funktionsblöcke desselben Blocktyps innerhalb der graphischen Darstellung. Die Größe der Funktionsblöcke kann vorab insbesondere aufgrund von Untersuchungen ermittelt werden, aufgrund derer besonders ansprechende oder übersichtliche Größen für die einzelnen Funktionsblöcke der verschiedenen Blocktypen gefunden werden.

Will ein Benutzer der erfindungsgemäßen graphischen Simulationsumgebung die Größe einzelner Funktionsblöcke ändern, so ist es nach einer Variante der erfindungsgemäßen Simulationsumgebung vorgesehen, dass der manuell veränderte Funktionsblock sofort automatisch auf seine voreingestellte Größe zurückgestellt wird.

Ein besonders übersichtliches Erscheinungsbild kann sich für die graphische Darstellung ergeben, wenn nach einer besonders bevorzugten Ausführungsform der erfindungsgemäßen graphischen Simulationsumgebung aufgrund der vorab definierten Kriterien die Größe eines Funktionsblocks eines Blocktyps relativ zu wenigstens einer Bezugsgröße vorgegeben ist. Die Bezugsgröße ist insbesondere eine Schriftgröße einer einem bestimmten Funktionsblock zugeordneten Beschriftung, die Länge der Beschriftung, eine Verwendung bestimmter Blocktypen, die Anzahl von Ein- und/oder Ausgängen eines Funktionsblocks und/oder die Anordnung der Funktionsblöcke der graphischen Darstellung zueinander. Insbesondere in Kombination mit der manuell nicht veränderbaren Größe der Funktionsblöcke ist es möglich, vorab besonders günstige Größen für die Funktionsblöcke festzulegen, wodurch bei Verwendung z.B. bestimmter Schriftgrößen oder bestimmter Blocktypen eine besonders ansprechende graphische Darstellung entsteht.

Die Lesbarkeit der graphischen Darstellung kann dann weiter verbessert werden, wenn nach einer weiteren Variante der erfindungsgemäßen Simulationsumgebung sich die Größen der Funktionsblöcke während des Erstellens und/oder nach Fertigstellung der graphischen Darstellung aufgrund der Bezugsgröße automatisch ändern. Insbesondere die nachträgliche automatische Anpassung der Größen der einzelnen Funktionsblöcke hat den Vorteil, dass das Erscheinungsbild den tatsächlichen Blocktypen der graphischen Darstellung automatisch angepasst werden kann.

Die Aufgabe der Erfindung wird auch gelöst durch eine graphische Simulationsumgebung eines mathematischen Simulationsprogramms für die graphische Darstellung einer zu simulierenden Funktion mittels Funktionsblöcken mehrerer Blocktypen, dadurch gekennzeichnet, dass sich die Größen der Funktionsblöcke eines Blocktyps aufgrund vorab definierter Kriterien während der Erstellung und/oder nach Fertigstellung der graphischen Darstellung automatisch ändern. Dabei ist es insbesondere vorgesehen, aufgrund der vorab definierten Kriterien die Größe eines Funktionsblocks eines Blocktyps relativ zu wenigstens einer Bezugsgröße zu verändern. Eine Bezugsgröße ist z.B. eine Schriftgröße einer einem bestimmten Funktionsblock zugeordneten Beschriftung, eine Verwendung bestimmter Blocktypen, eine Anzahl von Ein- und/oder Ausgängen des Funktionsblocks, eine Länge der Beschriftung des Funktionsblocks und/oder die Anordnung der Funktionsblöcke der graphischen Darstellung zueinander.

Die erfindungsgemäße graphische Simulationsumgebung unterstützt den Anwender beim Erstellen einer graphischen Darstellung, die nicht nur für die Simulation, sondern auch für eine Dokumentation vorgesehen ist. Der Anwender wird dahingehend entlastet, dass er während der Erstellung der graphischen Darstellung, die zunächst zum Zwecke der Simulation angefertigt wird, nicht durch-Überlegungen hinsichtlich einer-übersichtlichen Darstellung für die Dokumentation abgelenkt wird. Die Kriterien bzw. Bezugsgrößen der erfindungsgemäßen graphischen Simulationsumgebung werden bevorzugt zentral definiert, wodurch sich ein einheitliches Gesamtbild der mit der erfindungsgemäßen graphischen Simulationsumgebung erstellten graphischen Darstellungen ergibt. Dies führt zu einer kürzeren Entwicklungs- und Dokumentationszeit.

Ausführungsbeispiele erfindungsgemäßer graphischer Simulationsumgebungen sind beispielhaft in den schematischen Zeichnungen dargestellt. Es zeigen:
- Fig. 1: einen Rechner,
- Fig. 2: eine mit einer gewöhnlichen Simulationsumgebung erstellte graphische Darstellung und
- Fig. 3: eine mit erfindungsgemäßen Simulationsumgebungen erstellte graphische Darstellung.

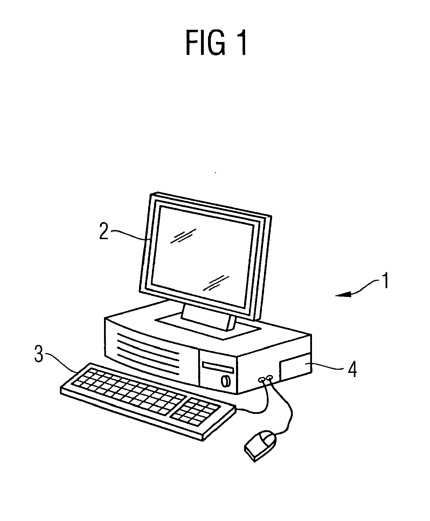

Die Figur 1 zeigt einen Rechner 1, auf dem im Falle des vorliegenden Ausführungsbeispiels ein Simulationsprogramm zum Simulieren von u.a. elektronischen Schaltungen oder Regel- und Steuerungen installiert ist. Auf dem Rechner 1 ist ferner eine gewöhnliche Simulationsumgebung und eine erfindungsgemäße Simulationsumgebung in Form von Rechnerprogrammen installiert. Die graphischen Simulationsumgebungen sind jeweils ein graphischer Editor, mit denen eine graphische Darstellung für die zu simulierende Schaltung, Regelung oder Steuerung mittels Funktionsblöcken verschiedener Blocktypen erstellt, auf dem Bildschirm 2 des Rechners 1 angezeigt und mit einem nicht dargestellten Drucker ausgedruckt werden kann. Aufgrund der graphischen Darstellung kann das Simulationsprogramm die der graphischen Darstellung zugeordneten Schaltung simulieren.

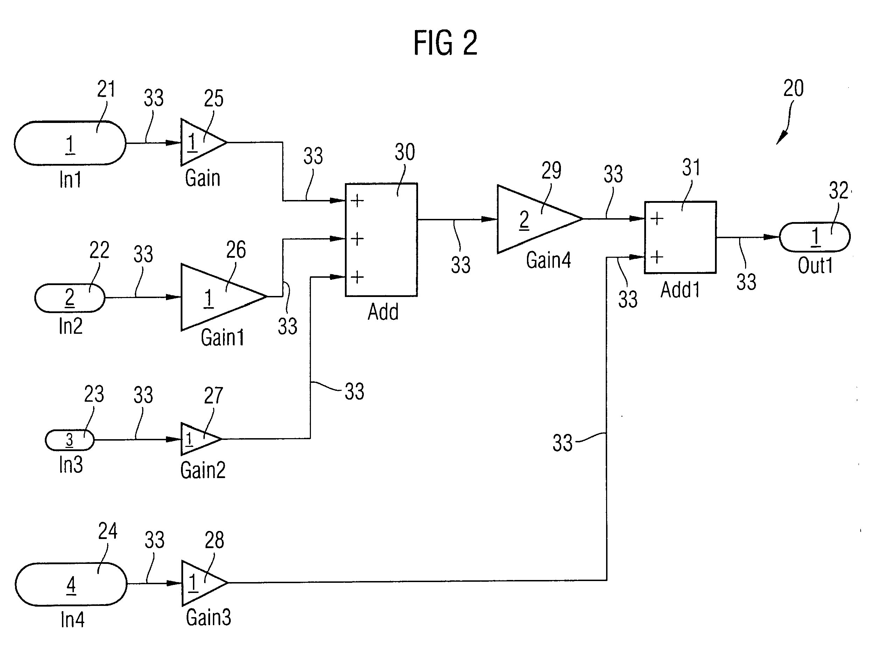

Die Figur 2 zeigt eine graphische Darstellung 20, die mit der gewöhnlichen Simulationsumgebung erstellt wurde. Bei der graphischen Darstellung 20 handelt es sich im Falle des vorliegenden Ausführungsbeispiels um einen Signalflussplan für eine zu simulierende Motorsteuerung. Im Falle des vorliegenden Ausführungsbeispiels umfasst die graphische Darstellung 20 mehrere Funktionsblöcke verschiedener Blocktypen. Dabei handelt es sich bei den dargestellten Blocktypen um einen Blocktyp "Eingang", einen Blocktyp "Ausgang", einen Blocktyp "Verstärker" und einem Blocktyp "Addierer". Die graphische Darstellung 20 umfasst hierbei einen ersten Funktionsblock 21, einen zweiten Funktionsblock 22, einen dritten Funktionsblock 23 und einen vierten Funktionsblock 24 vom Blocktyp "Eingang", einen fünften Funktionsblock 25, einen sechsten Funktionsblock 26, einen siebten Funktionsblock 27, einen achten Funktionsblock 28 und einen neunten Funktionsblock 29 vom Blocktyp "Verstärker", einen zehnten Funktionsblock 30 und einen elften Funktionsblock 31 vom Blocktyp "Addierer" und einen zwölften Funktionsblock 32 vom Blocktyp "Ausgang". Die einzelnen Funktionsblöcke 21 bis 32 sind für die Simulation der der graphischen Darstellung 20 zugeordneten Motorsteuerung mit entsprechendem Signalflusspfeilen 33 verbunden. Die gewöhnliche Simulationsumgebung ist derart ausgeführt, dass ein Benutzer der Simulationsumgebung die Größe der einzelnen Funktionsblöcke 21 bis 32 beliebig verändern kann.

Wie es aus der Figur 2 erkennbar ist, wird die Lesbarkeit der graphischen Darstellung 20 dadurch erschwert, dass Funktionsblöcke desselben Blocktyps der fertigen graphischen Darstellung 20 unterschiedlich groß sind. So sind im Falle des vorliegenden Ausführungsbeispiels der erste bis vierte Funktionsblock 21-24 des Blocktyps "Eingang" unterschiedlich groß. Dasselbe gilt für den fünften bis neunten Funktionsblock 25-29 des Blocktyps "Verstärker". Gut zu sehen ist ferner eine unterschiedliche Skalierung von Funktionsblöcken desselben Blocktyps zu einer bestimmten bereits festgelegten Schriftgröße für eine den Funktionsblöcken zugeordneten Beschriftung.

Um die Lesbarkeit der graphischen Darstellung 20 zu erhöhen, ist es zwar möglich, die einzelnen Funktionsblöcke 21 bis 32 manuell umzuskalieren. Dies ist jedoch nicht nur aufwändig, sondern es ist auch unwahrscheinlich, ein einheitliches Erscheinungsbild für verschiedene graphische Darstellungen, z.B. zweier Simulations- oder Modellebenen, zu erhalten.

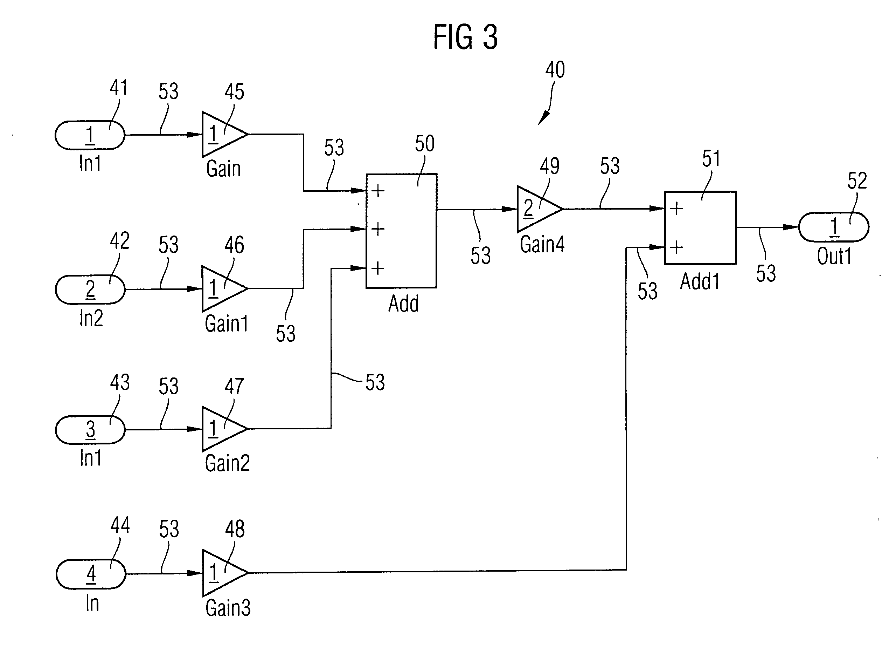

Im Falle des vorliegenden Ausführungsbeispiels läuft auf dem Rechner 1 noch ein einer ersten erfindungsgemäßen Simulationsumgebung zugeordnetes Rechnerprogramm. Die Figur 3 zeigt eine graphische Darstellung 40, die derselben Motorsteuerung zugeordnet ist, jedoch mit der ersten erfindungsgemäßen Simulationsebene erstellt wurde. Im Falle des vorliegenden Ausführungsbeispiels ist die graphische Darstellung 40 auf dem Bildschirm 2 des Rechners 1 visualisiert.

Im Falle des vorliegenden Ausführungsbeispieles definiert ein nicht näher dargestellter Benutzer der erfindungsgemäßen graphischen Simulationsumgebung bei der Erstellung der graphischen Darstellung 40 zunächst die Schriftgröße für die zu verwendenden Funktionsblöcke mit der Tastatur 3 des Rechners 1. Daraufhin berechnet das auf dem Rechner 1 laufende und der erfindungsgemäßen Simulationsumgebung zugeordnete Rechnerprogramm Blockgrößen der einzelnen Funktionsblöcke der von der Simulationsumgebung bereit gestellten Blocktypen. Im Falle des vorliegenden Ausführungsbeispiels sind die den wählbaren Schriftgrößen zugeordneten Blockgrößen in einer Datenbank 4 des Rechners 1 hinterlegt und die den Schriftgrößen zugeordneten Blockgrößen wurden vorab definiert.

Anschließend erstellt der nicht dargestellte Benutzer mit dem Rechner 1 die in der Figur 3 dargestellte graphische Darstellung 40, die einen ersten Funktionsblock 41, einen zweiten Funktionsblock 42, einen dritten Funktionsblock 43, und einen vierten Funktionsblock 44 vom Blocktyp "Eingang" umfasst. Aufgrund der vorher gewählten Schriftgröße der einzelnen Funktionsblöcke, z.B. "In" für den ersten bis vierten Funktionsblock 41-44 des Blocktyps "Eingang", wurde die in der Fig. 3 gezeigte einheitliche und vom Benutzer nicht veränderbare Größe dieser Funktionsblöcke festgelegt.

Die graphische Darstellung 40 weist ferner eine fünften Funktionsblock 45, eine sechsten Funktionsblock 46, eine siebten Funktionsblock 47, einen achten Funktionsblock 48 und einen neunten Funktionsblock 49 vom Blocktyp "Verstärker" auf. Die Größe dieser Funktionsblöcke wurde ebenfalls aufgrund der vorab für diesen Blocktyp gewählten Schriftgröße festgelegt.

Die graphische Darstellung 40 umfasst ferner einen zehnten Funktionsblock 50 und einen elften Funktionsblock 51 vom Blocktyp "Addierer". Die Größen dieser Funktionsblöcke 50, 51 hängt nicht nur von der vorab gewählten Schriftgröße, sondern auch von der Anzahl der Ein- und Ausgänge der einzelnen Funktionsblöcke 50, 51 vom Blocktyp "Addierer" ab. So hat im Falle des vorliegenden Ausführungsbeispiels der zehnte Funktionsblock 50 vom Blocktyp "Addierer" drei Eingänge, der elfte Funktionsblock 51 vom Blocktyp "Addierer" dagegen nur zwei Eingänge. Das auf dem Rechner 1 laufende und der erfindungsgemäßen Simulationsumgebung zugeordnete Rechnerprogramm hat im Falle des vorliegenden Ausführungsbeispiels die Ausdehnungen der beiden Funktionsblöcke 50, 51 des Blocktyps "Addierer" in horizontaler Richtung automatisch aufgrund der gewählten Schriftgröße identisch gewählt. Die Ausdehnungen der beiden Funktionsblöcke 50, 51 in vertikale Richtung wurde dagegen automatisch aufgrund der gewählten Anzahl von Ein- und Ausgängen festgelegt.

Die graphische Darstellung 40 hat ferner noch einen zwölften Funktionsblock 52 vom Blocktyp "Ausgang", dessen Größe automatisch von dem auf dem Rechner 1 laufenden Rechnerprogramm gleich der Größe der Funktionsblöcke 41-44 des Blocktyps "Eingang" festgelegt wurde.

Die einzelnen Funktionsblöcke 41-52 sind ferner mit Signalflusspfeilen 53 verbunden.

Im Falle des vorliegenden Ausführungsbeispiels ist die erfindungsgemäße Simulationsumgebung derart ausgeführt, dass der Benutzer die Größen der einzelnen Funktionsblöcke 41-52 nicht verändern kann. Versucht er dies trotzdem, so wird der entsprechende Funktionsblock sofort automatisch auf seine voreingestellte Größe zurückgestellt.

Bei dem beschriebenen Ausführungsbeispiel sind die Größen der einzelnen Funktionsblöcke während der Erstellung der graphischen Darstellung 40 nicht veränderbar und aufgrund der vorab gewählten Schriftgröße festgelegt. Alternativ ist es möglich, dass die Größen der Funktionsblöcke bis zu einer maximalen und fest vorgegebene Größe während des Erstelens der graphischen Darstellung 40 veränderbar sind. Auch ist es möglich, dass die Größen von Funktionsblöcken bestimmter Blocktypen in wenigstens einer Richtung unveränderbar sind, eine relative Seitenlänge von Funktionsblöcken eines Blocktyps bei einer manuellen Veränderung eines dieser Funktionsblöcke konstant bleibt oder eine Verstellschrittweite eines Funktionsblocks eines Blocktyps vorgegeben ist.

Im Falle des vorliegenden Ausführensbeispiels läuft auf dem Rechner 1 ein weiteres Rechnerprogramm, das einer zweiten erfindungsgemäßen Simulationsumgebung zugeordnet ist. Wenn mit dieser Simulationsumgebung eine graphische Darstellung erstellt wird, so kann der Benutzer zunächst die Größen der einzelnen Funktionsblöcke während des Erstellens der graphischen Darstellung beliebig ändern. Es entsteht somit z.B. die in der Fig. 2 gezeigte graphische Darstellung 20.

Wenn die graphische Darstellung 20 fertig ist, dann kann der Benutzer im Falle des vorliegenden Ausführungsbeispiels durch eine entsprechende Eingabe mit der Tastatur 3 des Rechners 1 eine Programmroutine des der zweiten erfindungsgemäßen Simulationsumgebung zugeordneten Rechnerprogramms starten, die daraufhin die graphische Darstellung 20 bezüglich der verwendeten Blocktypen, der Anordnung einzelner Funktionsblöcke zueinander und der verwendeten Schriftgröße analysiert. Aufgrund der Analyse vergleicht die Programmroutine in der Datenbank 4 abgelegte Beziehungen, aufgrund derer die Programmroutine automatisch die Blockgrößen der Funktionsblöcke 21-32 der graphischen Darstellung 20 automatisch derart anpasst, dass aus der in der Fig. 2 dargestellten graphischen Darstellung 20 die in der Fig. 3 gezeigte graphische Darstellung 40 entsteht. Die in der Datenbank 4 gespeicherten Beziehungen enthalten eine Information über die zu verwendenden Blockgrößen in Abhängigkeit der Schriftgröße, der Art verwendeter Blocktypen, der Anzahl von Ein- und Ausgängen eines Funktionsblocks und der Anordnung verschiedener Funktionsblöcke zueinender. Für die automatische Größenanpassung der einzelnen Funktionsblöcke 21-32 werden im Falle des vorliegenden Ausführungsbeispiels zunächst die Schwerpunkte der einzelnen Funktionsblöcke 21-32 ermittelt und anschließend die Größen der Funktionsblöcke derart angepasst, dass die Schwerpunkte der angepassten Funktionsblöcke 41-53 der in der Fig. 3 gezeigten graphischen Darstellung 40 mit den Schwerpunkten der ursprünglichen Funktionsblöcke 21-33 der in der Fig. 2 gezeigten graphischen Darstellung 20 übereinstimmen.

Im Falle des vorliegenden Ausführungsbeispiels wurde für die automatische Größenanpassung die Schwerpunkte der entsprechen-den Funktionsblöcke ermittelt, d.h. die Funktionsblöcke 41-53 der angepassten graphischen Darstellung 40 sind bezüglich der Schwerpunkte der Funktionsblöcke 21-32 der ursprünglichen graphischen Darstellung 20 ausgerichtet. Alternativ ist es insbesondere auch möglich, die einzelnen Funktionsblöcke 41-53 der angepassten graphischen Darstellung 40 bezüglich einer bestimmten Seitenlinie oder Ecke der Funktionsblöcke 21-32 der ursprünglichen graphischen Darstellung 20 auszurichten.

## Patentansprüche

1. Graphische Simulationsumgebung eines mathematischen Simulationsprogramms für die graphische Darstellung (40) einer zu simulierenden Funktion mittels Funktionsblöcken (41-53) mehrerer Blocktypen,
**dadurch gekennzeichnet,**
**dass** die Größen der Funktionsblöcke (41-53) eines Blocktyps nur innerhalb von vorab definierten Kriterien manuell veränderbar sind.

2. Graphische Simulationsumgebung nach Anspruch 1, die aufgrund der vorab definierten Kriterien die Größen von Funktionsblöcken (41-53) eines Blocktyps in wenigstens einer Richtung unverändert lässt, eine relative Seitenlänge von Funktionsblöcken (41-53) eines Blocktyps bei einer manuellen Veränderung eines dieser Funktionsblöcke (31-36) konstant lässt, eine Verstellschrittweite eines Funktionsblocks (41-53) eines Blocktyps vorgibt und/oder einen Funktionsblock eines Blocktyps nur bis zu einer vorgegebenen Maximalgröße verändern lässt.

3. Graphische Simulationsumgebung nach Anspruch 1, die die Größen von Funktionsblöcken (41-53) eines Blocktyps unverändert lässt.

4. Graphische Simulationsumgebung nach Anspruch 3, die ein einen Funktionsblock (41-53) eines Blocktyps bei manueller Grö-ßenänderung sofort automatisch auf seine voreingestellte Größe zurückstellt.

5. Graphische Simulationsumgebung nach einem der Ansprüche 1 bis 4, die aufgrund der vorab definierten Kriterien die Größe eines Funktionsblocks (41-53) eines Blocktyps relativ zu wenigstens einer Bezugsgröße vorgibt.

6. Graphische Simulationsumgebung nach Anspruch 8, bei der die Bezugsgröße eine Schriftgröße einer einem bestimmten Funktionsblock (41-53) zugeordneten Beschriftung, eine Verwendung bestimmter Blocktypen, eine Anzahl von Ein- und/oder Ausgängen des Funktionsblocks, eine Länge der Beschriftung des Funktionsblocks und/oder die Anordnung der Funktionsblöcke (41-53) der graphischen Darstellung (40) zueinander ist.

7. Graphische Simulationsumgebung nach Anspruch 9, die die Größen der Funktionsblöcke (41-53) in Abhängigkeit der Bezugsgröße während der Erstellung und/oder nach Fertigstellung der graphischen Darstellung (40) automatisch ändert.

8. Graphische Simulationsumgebung eines mathematischen Simulationsprogramms für die graphische Darstellung (40) einer zu simulierenden Funktion mittels Funktionsblöcken (41-53) mehrerer Blocktypen,
**dadurch gekennzeichnet,**
**dass** sich die Größen der Funktionsblöcke (41-53) eines Blocktyps aufgrund vorab definierter Kriterien während der Erstellung und/oder nach Fertigstellung der graphischen Darstellung (40) automatisch ändern.

9. Graphische Simulationsumgebung nach Anspruch 8, die aufgrund der vorab definierten Kriterien die Größe eines Funktionsblocks (41-53) eines Blocktyps relativ zu wenigstens einer Bezugsgröße vorgibt.

10. Graphische Simulationsumgebung nach Anspruch 9, bei der die Bezugsgröße eine Schriftgröße einer einem bestimmten Funktionsblock (41-53) zugeordneten Beschriftung, eine Verwendung bestimmter Blocktypen, eine Anzahl von Ein- und/oder Ausgängen des Funktionsblocks, eine Länge der Beschriftung des Funktionsblocks und/oder die Anordnung der Funktionsblöcke (41-53) der graphischen Darstellung (40) zueinander ist.

11. Verfahren zum Erzeugen einer graphischen Darstellung mit einer graphische Simulationsumgebung eines mathematischen Simulationsprogramms, aufweisend folgende Verfahrensschritte:
- Erzeugen einer ersten graphischen Darstellung (20) einer zu simulierenden Funktion mittels Funktionsblöcken (21-33) mehrerer Blocktypen, und
- automatisches Ändern der Größen der Funktionsblöcke (21-33) eines Blocktyps aufgrund vorab definierter Kriterien während der Erstellung und/oder nach Fertigstellung der graphischen Darstellung (20), sodass eine zweite graphische Darstellung (40) mit angepassten Funktionsblöcken (41-53) entsteht.

12. Verfahren nach Anspruch 11, bei dem aufgrund der vorab definierten Kriterien die Größe eines Funktionsblocks (41-53) eines Blocktyps relativ zu wenigstens einer Bezugsgröße vorgegeben ist.

13. Verfahren nach Anspruch 12, bei dem die Bezugsgröße eine Schriftgröße einer einem bestimmten Funktionsblock (41-53) zugeordneten Beschriftung, eine Verwendung bestimmter Blocktypen, eine Anzahl von Ein- und/oder Ausgängen des Funktionsblocks, eine Länge der Beschriftung des Funktionsblocks und/oder die Anordnung der Funktionsblöcke (41-53) der graphischen Darstellung (40) zueinander ist.
